Europäisches Patentamt

European Patent Office

Office européen des brevets

(11) Numéro de publication : **0 459 882 A2**

# (12) DEMANDE DE BREVET EUROPEEN

(21) Numéro de dépôt : **91401356.0**

(22) Date de dépôt : **27.05.91**

(51) Int. Cl.⁵ : **H01L 39/14, H01L 39/22**

(30) Priorité : **01.06.90 FR 9006877**

(43) Date de publication de la demande :
**04.12.91 Bulletin 91/49**

(84) Etats contractants désignés :
**DE GB**

(71) Demandeur : **THOMSON-CSF**
**51, Esplanade du Général de Gaulle**
**F-92800 Puteaux (FR)**

(72) Inventeur : **Hartemann, Pierre**
**THOMSON-CSF SCPI Cédex 67**
**F-92045 Paris la Défense (FR)**

(74) Mandataire : **Guérin, Michel et al**
**THOMSON-CSF SCPI**
**F-92045 PARIS LA DEFENSE CEDEX 67 (FR)**

(54) **Dispositif haute fréquence accordable.**

(57)    Dispositifs    haute    fréquence    accordables
comportant :
— une couche mince supraconductice (1)
d'épaisseur (d) inférieure à la profondeur de
pénétration ($\lambda_L$) du champ magnétique disposée sur une couche de diélectrique (2)
— ainsi que des moyens (3) permettant de
faire varier la densité des paires de Cooper de la
couche mince supraconductrice (1).
Applications : Absorbants hyperfréquences.

FIG.1

EP 0 459 882 A2

L'invention concerne des dispositifs haute fréquence accordables à base de matériaux supraconducteurs.

Un dispositif de traitement d'ondes électromagnétiques peut être constitué d'un élément en matériau supraconducteur ainsi que d'un élément en diélectrique associé à cet élément supraconducteur.

L'épaisseur d'un élément en matériau supraconducteur étant inférieur à la longueur de pénétration $\lambda_L$ du champ magnétique, le dispositif possède une inductance supplémentaire dite cinétique due à l'élément supraconducteur qui s'ajoute à l'inductance magnétique ordinaire.

Cette inductance rend compte de l'énergie cinétique des électrons supraconducteurs. Pour des couches très minces, elle est proportionnelle au carré de la profondeur de pénétration $\lambda_L$ du champ magnétique et donc inversement proportionnelle à la densité de paires de Cooper.

Pour une densité de paires de Cooper déterminée l'inductance cinétique est fixée.

L'invention prévoit des moyens permettant de modifier à volonté l'inductance supplémentaire cinétique. Pour cela, ces moyens sont tels qu'ils permettent de modifier la densité de paires de Cooper.

Cette densité de paires de Cooper peut être changée par :
— variation de la température,
— application d'un courant de polarisation,
— application d'un champ magnétique,
— éclairage du supraconducteur par un rayonnement.

L'invention concerne donc un dispositif haute fréquence accordable, caractérisé en ce qu'il comporte au moins une couche mince supraconductrice d'épaisseur inférieure à la longueur de pénétration $\lambda_L$ du champ magnétique déposée sur une première couche diélectrique, ainsi que des moyens permettant de faire varier la densité des paires de Cooper de la couche mince supraconductrice.

Les différents objets et caractéristiques de l'invention apparaîtront dans la description qui va suivre faite à titre d'exemple et dans les dessins annexés qui représentent :
— la figure 1, un exemple de réalisation d'un dispositif selon l'invention,
— les figures 2 et 3, des courbes de fonctionnement du dispositif de la figure 1,
— la figure 4a, un dispositif selon l'invention fonctionnant en absorbant, et la figure 4b, des courbes de fonctionnement de ce dispositif,
— la figure 5a, une variante du dispositif de la figure 4a et la figure 5b, des courbes de fonctionnement de ce dispositif,
— les figures 6a à 6d, un dispositif bicouches déphaseur en réflexion des ondes électromagnétiques et ses courbes de fonctionnement,
— la figure 7, un exemple de réalisation d'un brouilleur de polarisation,
— la figure 8a à 8c, un réducteur actif de surface équivalente radar,
— la figure 9, un déflecteur d'onde électromagnétique appliquant le dispositif de l'invention,
— la figure 10, un guide d'onde de forme linéaire utilisable comme déphaseur,

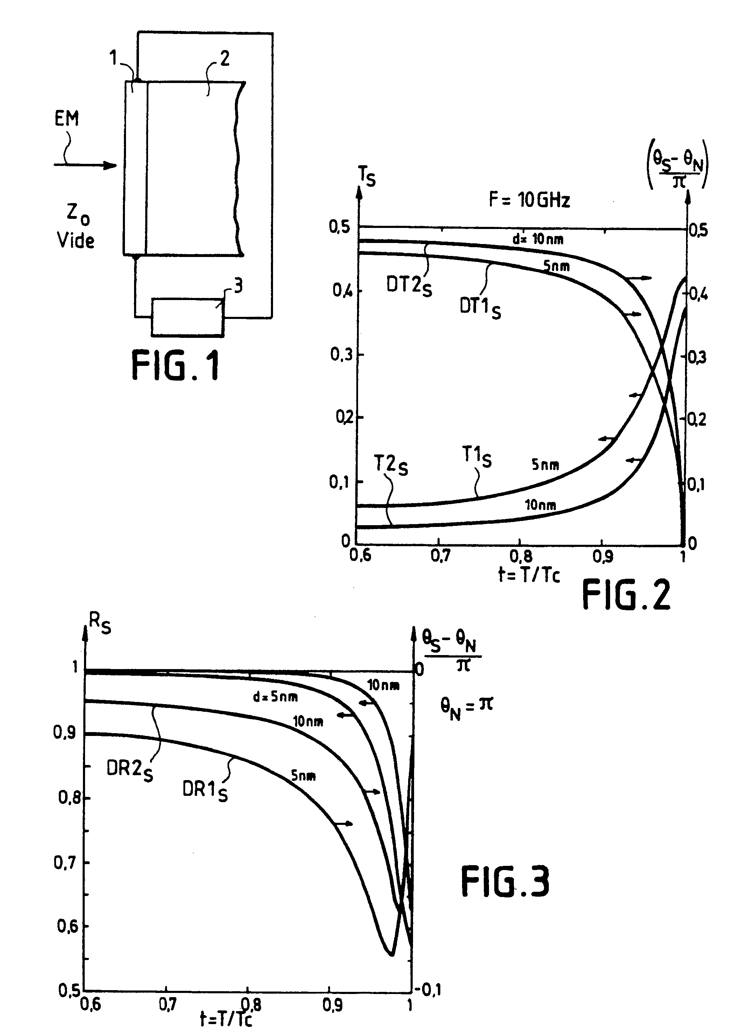

Le dispositif simplifié de la figure 1 comporte un élément en matériau diélectrique 2 considérée d'épaisseur infinie portant sur une face une couche 1 d'un matériau supraconducteur et recevant une onde électromagnétique EM. L'épaisseur de la couche 1 est inférieure à la profondeur de pénétration du champ magnétique $\lambda_L$. Des moyens 3 permettent d'obtenir une variation de densité de paires de Cooper par exemple en injectant un courant I. Mais tous les autres moyens permettant de modifier la densité de paires de Cooper peuvent convenir.

Dans un matériau supraconducteur, une élévation de température induit une réduction de la densité de paires de Cooper et donc la profondeur de pénétration $\lambda_L$ augmente. Les coefficients de transmission et de réflexion de EM dépendent donc de la température. Tous les procédés permettant de faire varier la densité des paires de Cooper auront les mêmes effets que la température. Des résultats théoriques sont présentés dans la suite en fonction de la température réduite t (rapport de la température de fonctionnement sur la température critique ). Quand t est égal 1, la couche est dans l'état normal. Les courbes de la figure 1, calculées pour 10 GHz à l'aide du modèle à deux fluides, montrent en fonction de t, le coefficient de transmission $T_s$ et son déphasage, divisé par $\pi$ par rapport au déphasage introduit par la couche dans l'état normal. La courbe $T1_S$ représente la courbe du coefficient de transmission pour une épaisseur de la couche 1 de 5 nm et la courbe $T2_S$ représente le même type de courbe pour une épaisseur de la couche 1 de 10 nm. Les courbes $DT1_S$ et $DT2_S$ représentent les déphasages introduits lors de la transmission pour des épaisseurs de couches de 5 et 10 nm respectivement. La figure 3 représente des courbes de variation du coefficient de réflexion $R_s$ et le déphasage associé divisé par $\pi$ comme pour la transmission. On trouve donc sur la figure 3 des courbes de coefficient de réflexion $R1_S$ et $R2_S$ (pour des épaisseurs de la couche 1 de 5 et 10 nm) et des courbes de déphasage à la réflexion $DR1_S$ et $DR2_S$ (pour ces épaisseurs de couches). Les effets de la couche supraconductrice varient beaucoup pour les températures réduites supérieures à 0,8. En particulier, le déphasage à la réflexion présente un maximum qui peut être supérieur à 10°.

Des absorbants accordables peuvent être réalisés en exploitant les variations des coefficients de réflexion et transmission d'une couche très mince supraconductrice en fonction de la densité de paires de Cooper.

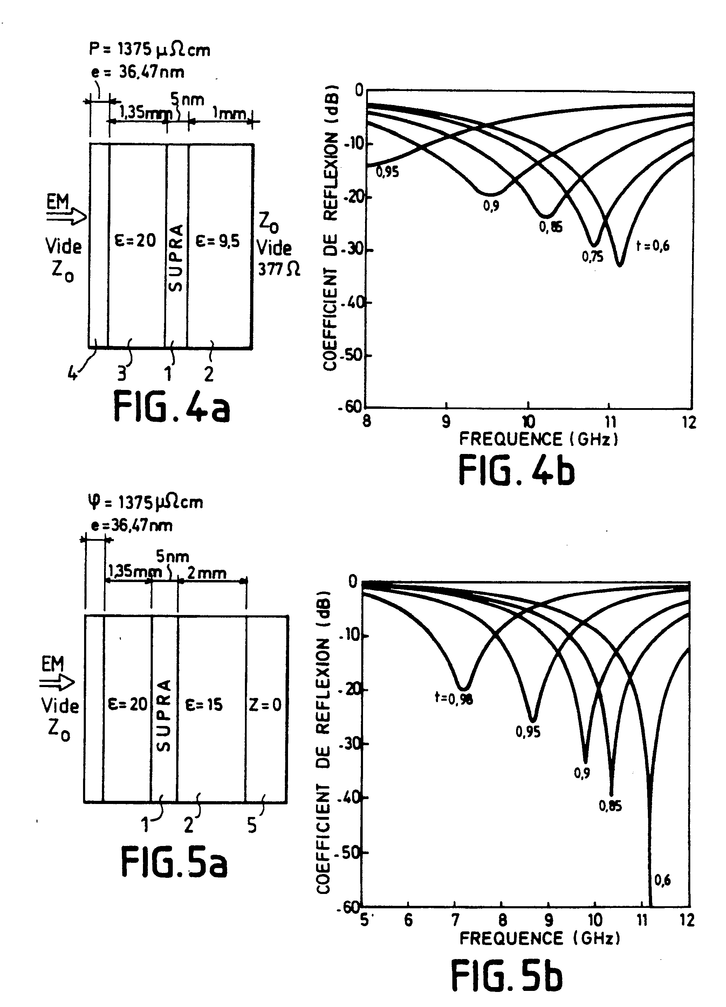

La figure 4a représente un écran multicouche comportant une couche 1 de supraconducteur enserrée entre une couche 2 de diélectrique et une couche 3 de diélectrique. Cette couche 3 est recouverte par une couche de carbone 4 très fine de dissipation thermique recevant une onde électromagnétique EM. De part et d'autre de cette structure c'est le vide.

La structure de la figure 5a est analogue à celle de la figure 4a mais la couche 2 de diélectrique est recouverte par une couche épaisse conductrice 5 d'impédance d'onde considérée comme nulle.

La première couche 4 traversée par les ondes présente une résistance de surface de 377 ohms égale à l'impédance d'onde du vide. Les structures de la figure 4a étant constituées d'un écran disposé dans le vide et celle de la figure 5a étant appliquée sur un milieu très conducteur d'impédance d'onde nulle (métal), présentent des courbes de coefficients de réflexion (figures 4b et 5b) différentes. Des domaines d'accord de plusieurs gigahertz peuvent être obtenus par variation de température de la couche supraconductrice ou par d'autres procédés de variation de densité de paires d'électrons.

L'inductance cinétique d'un carré de côté unité d'une couche supraconductrice d'épaisseur très inférieure à la profondeur de pénétration du champ magnétique $\lambda_L$ a pour expression $L_s$

$$L_s = \mu_o \lambda^2_L / d$$

où :

d = épaisseur de la couche supraconductrice

$\mu_o$ = perméabilité du vide

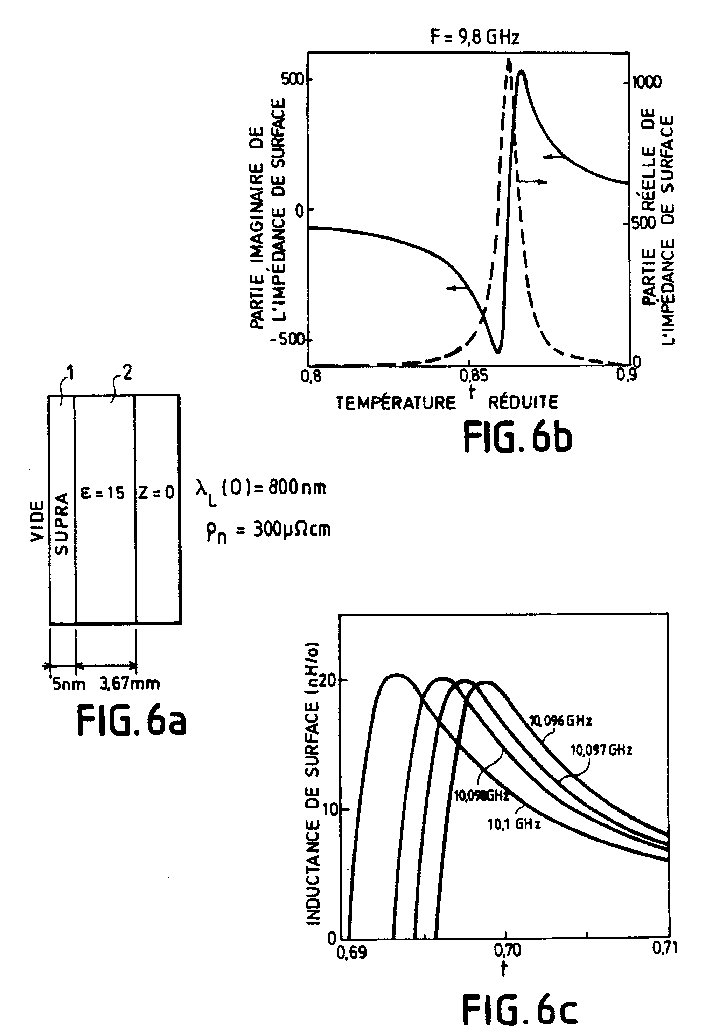

L'inductance de surface d'une telle couche est augmentée considérablement en disposant un diélectrique à pertes négligeables d'épaisseur convenables $e_1$ entre la couche supraconductrice très mince 1 et une plaque épaisse 5 de métal normal très conducteur comme cela est représenté en figure 6a. L'épaisseur $e_1$ est voisine d'un multiple de la demi-longueur d'onde dans le diélectrique :

$$e_1 \sim k \lambda_o / 2 \sqrt{\varepsilon_1} - \lambda^2_L / d$$

où :

– k nombre entier positif

– $\lambda_L$ est la profondeur de pénétration du champ magnétique,

– $\lambda_o$ est la longueur de l'onde dans le vide,

– $\varepsilon_1$ est la permittivité relative du diélectrique.

Par exemple, pour une couche de supraconducteur de profondeur de pénétration à 0 K de 800 nm, d'épaisseur de la couche supraconductrice de 1 de 5 nm, l'épaisseur 1 de la couche 2 doit être de 3, 67 mm pour une permittivité $\varepsilon_1$ de 15. Si le supraconducteur a une résistivité à l'état normal de 300 $\mu\Omega$ .cm le gain maximal d'inductance de surface à 10 Ghz est de 48 à la température réduite 0, 786. Ces valeurs ont été calculées à l'aide du modèle à deux fluides. La valeur utilisée (800 nm) pour la profondeur de pénétration est voisine de celle mesurée dans une direction pour les supraconducteurs à haute température critique comme par exemple Y Ba$_2$ Cu$_3$ O$_7$. La direction du champ magnétique est alors parallèle à l'axe cristallographique a ou b et la direction de pénétration est parallèle à b ou a. Comme le montrent les figures 6b et 6c, l'inductance de surface du bicouche de la figure 6a dépend fortement de la température réduite et varie très rapidement d'une valeur négative (capacité) à une valeur positive. De plus, la partie réelle de l'impédance de surface présente un pic à la température correspondant à la valeur nulle de l'inductance de surface (voir figure 6b). Elle est fonction des valeurs des paramètres du supraconducteur.

L'invention peut être employée comme absorbant d'ondes électromagnétiques à bande étroite puisque l'impédance de surface peut être purement réelle et ajustée à 377 $\Omega$ pour une valeur de la fréquence, de la profondeur de pénétration et de la résistivité du supraconducteur avant la transition.

Malgré l'augmentation de la résistance de surface, cette structure en bicouche peut être aussi avantageusement utilisée dans divers dispositifs commandables électroniquement.

L'invention peut être appliquée pour la réalisation de brouilleurs de signatures polarimétriques radar.

Un tel brouilleur exploite les propriétés du bicouche précédemment décrit et la forte anisotropie des supraconducteurs à haute température critique. En effet, par exemple pour une couche de Y Ba$_2$ Cu$_3$ O$_7$ d'axe optique c dans le plan, la profondeur de pénétration à O K du champ magnétique dans la direction perpendiculaire à la couche dépend de la direction de polarisation du champ magnétique. Elle est voisine de 800 nm quand la polarisation est parallèle à l'axe a ou b et de 140 nm pour une polarisation parallèle à l'axe c.

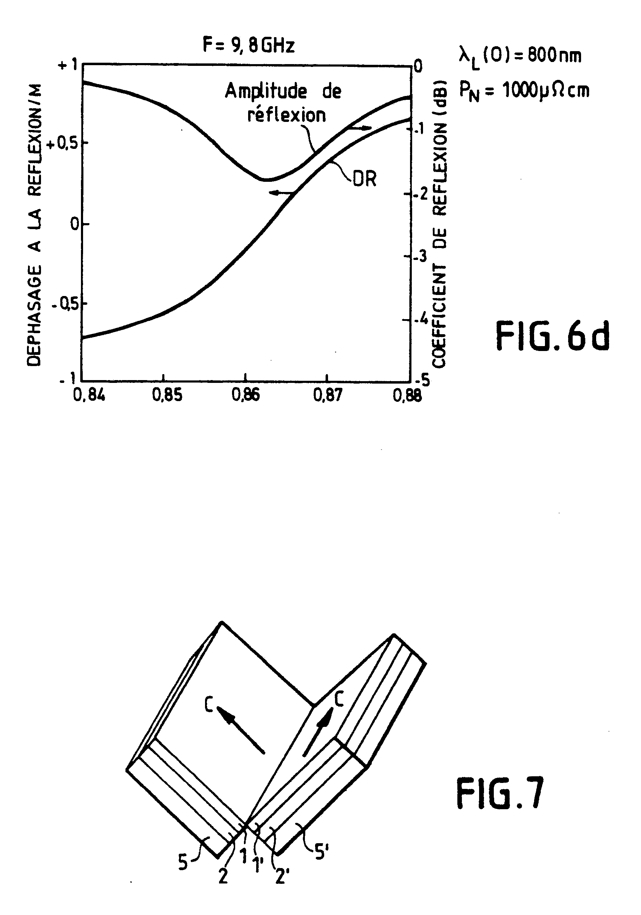

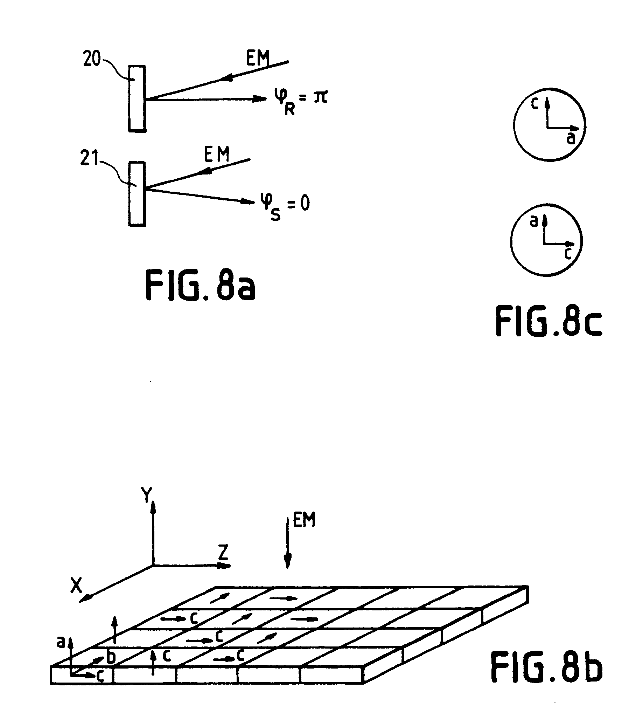

Pour la polarisation correspondant à une profondeur de pénétration de 800 nm, le déphasage à la réflexion sur le bicouche varie de $- 0, 7 \pi$ à $+ 0, 7 \pi$ pour une température réduite variant de 0, 84 à 0, 88 ( voir la courbe DR sur la figure 6d) tandis que pour la polarisation perpendiculaire ($\lambda_L = 140$ nm) le déphasage à la réflexion reste égal à $- \pi$. Donc, en ajustant la densité de paires de Cooper, il est possible d'induire une altération après réflexion de la polarisation d'une onde incidente polarisée linéairement. On peut obtenir une rotation de polarisation, une polarisation circulaire ou elliptique. Ce dispositif est inefficace si la polarisation incidente est parallèle à l'axe c. Pour éviter cet inconvénient on peut utiliser des dispositifs à deux réflexions du type dièdres composés de plaquettes supraconductrices à axes C perpendiculaires ( voir figure 7 ). Une modification après réflexion peut être aussi obtenue si la polarisation incidente est circulaire et le sens de la polarisation peut être inversé.

L'invention peut également être appliquée à la réalisation d'un réducteur actif de surface équivalente radar autour d'une fréquence. Comme cela est représenté en figures 8a à 8c, certains éléments tels que l'élément 20 sont en bicouches supraconducteurs et avec un axe c vertical. D'autres éléments tels que l'élément 21 sont réalisés en bicouches supraconducteurs commandables d'axe C horizontal. Pour une fréquence déterminée on ajuste la densité des paires de Cooper des bicouches pour obtenir une variation de $\pi$ du déphasage à la réflexion sur 20 et 21 pour les deux composantes des champs électromagnétiques.

On peut disposer côte à côte une pluralité de dispositifs dont les axes cristallographiques sont perpendiculaires. Par exemple, sur la figure 8b, on a représenté un ensemble de dispositifs disposés selon un plan XY. Il est à noter que, pour simplifier, la "peau" oui "revêtement" de la figure 8b est représentée sous forme plane mais cela n'est pas obligatoire, elle pourrait être de forme courbe dans l'espace. Certains éléments ont leur axe c parallèle à l'axe Y, d'autres leur axe c parallèle à l'axe X. La direction de polarisation du champ magnétique EM incident est quelconque dans le plan XY. Dans ces conditions, en se référant à la figure 6d, le déphasage à la réflexion entre les éléments adjacents peut être ajusté à $\pi$ pour les deux composantes de la polarisation. De plus, les dispositifs sont commandés indépendamment électroniquement ce qui permet d'avoir des réflexions avec une multitude de déphasages différents et de modifier à volonté la signature radar.

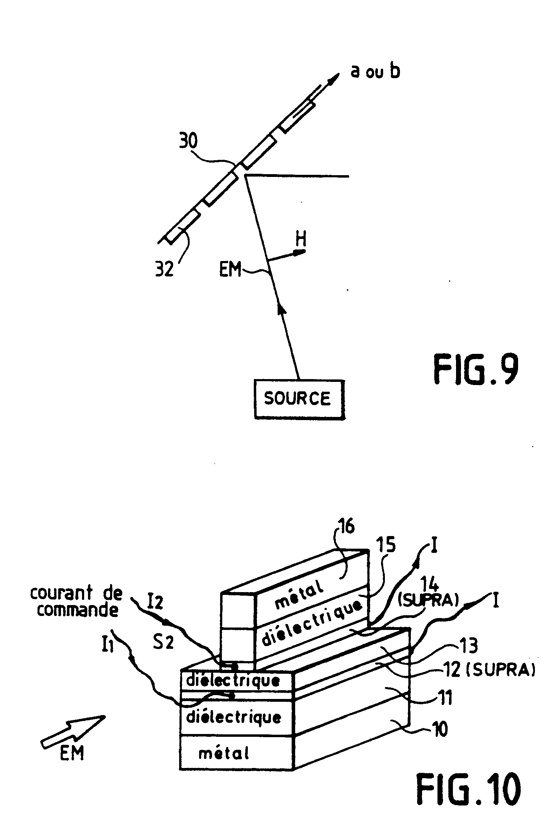

L'invention est également applicable à un déviateur ou déflecteur d'ondes électromagnétiques tel que représenté en figure 9. Il comporte un dispositif 30 constitué d'un réseau d'éléments supraconducteurs bicouches de dimensions inférieures à la longueur d'onde du rayonnement émis par la source. Chaque élément de 30 réfléchit en le diffractant une partie du rayonnement incident. Pour une polarisation du champ magnétique perpendiculaire à l'axe c on peut contrôler la phase à la réflexion de chaque élément par les méthodes décrites précédemment. Dans ces conditions, on peut obtenir un balayage angulaire du faisceau réfléchi en ajustant la phase des faisceaux réfléchis sur chaque élément. Pour fonctionner avec un faisceau réfléchi de direction de polarisation variable, il est nécessaire d'ajouter en champ proche un rotateur de polarisation qui peut être réalisé en réfléchissant 2 fois le faisceau sur des plaquettes supraconductrices d'axes c perpendiculaires comme cela est représenté en figure 7.

A fréquence fixe, l'argument de l'impédance de surface du bicouche varie rapidement (dans un intervalle de 0,03 environ en température réduite) entre -$\pi/2$ et $\pi/2$ en fonction de la densité de paires de Cooper. Des déphaseurs en guide d'onde plan (microruban par exemple) peuvent être réalisés comme cela est représenté en figure 10.

Le dispositif de la figure 10 comporte une plaque métallique 10 recouverte d'une plaque de diélectrique 11 recouverte elle-même d'une couche 12 d'un matériau supraconducteur et d'une couche de diélectrique 13.

Sur la couche de diélectrique 13 est déposé un élément en matériau supraconducteur 14 ayant sur la couche 13 une forme linéique. Cet élément 14 est revêtu d'une couche de diélectrique 15 et d'une couche 16 métallique. L'élément 14, la couche 15, et la couche 16 forment l'élément de guidage de l'onde électromagnétique. A titre d'exemple, cet ensemble a une forme rectiligne mais il pourrait avoir toute autre forme. Des connexions électriques telles que 17 et 18 permettent d'alimenter par un courant I1 la couche supraconductrice 12 et par un courant I2 l'élément supraconducteur 14, ce qui permet de commander électroniquement le dispositif. Le contrôle des impédances de surface en S1 (Interface des couches 12 et 13) et en S2 (interface de la couche 13 et de l'élément supraconducteur 14) permettent de régler le déphasage.

Pour une inductance de surface constante et une densité de paires de Cooper variable, la fréquence change. Il est donc possible de réaliser des résonateurs accordables avec ce type de dispositif.

Enfin l'invention est applicable à la réalisation de bolomètres. Il est bien évident que l'élévation de température peut être obtenue par un rayonnement incident et les déphaseurs à bicouche peuvent être utilisés pour mesurer une puissance électromagnétique incidente. On peut faire porter la mesure sur le déphasage, en réalisant par exemple un oscillateur et en mesurant sa fréquence.

Il est bien évident que la description n'a été faite qu'à titre d'exemple et que d'autres variantes peuvent être envisagées sans sortir du cadre de l'invention.

## Revendications

1. Dispositif haute fréquence accordable, caractérisé en ce qu'il comporte au moins une couche mince supraconductrice (1) d'épaisseur (d) inférieure à la longueur de pénétration ($\lambda_L$) du champ magnétique disposée sur une première couche diélectrique (2), ainsi que des moyens permettant de faire varier la densité des paires de Cooper de la couche mince supraconductrice (1).

2. Dispositif selon la revendication 1, caractérisé en ce que les moyens permettant de faire varier la densité des paires de Cooper de la couche mince supraconductrice (1) sont :
   – soit des moyens pour faire varier la température de la couche mince supraconductrice (1) ;
   – soit des moyens d'application d'un courant de polarisation de la couche mince supraconductrice (1) ;

– soit des moyens d'application d'un champ magnétique ;

– soit des moyens d'application d'un rayonnement optique.

3. Dispositif absorbant d'ondes haute fréquence selon la revendication 1, caractérisé en ce qu'il comporte une deuxième couche d'un matériau diélectrique (3) recouvrant la couche mince supraconductrice (1), une couche mince (4) d'un matériau plus ou moins conducteur recouvrant la deuxième couche diélectrique (3) et recevant l'onde à absorber, l'épaisseur (e) de la couche (4) étant prise en fonction de la résistivité du matériau qui la constitue de telle façon que l'impédance de surface soit sensiblement égale à l'impédance d'onde du milieu ambiant (377 $\Omega$ ).

4. Dispositif absorbant d'ondes hyperfréquences selon la revendication 3, caractérisé en ce que la première couche diélectrique (2) est accolée à un substrat (5) d'impédance d'onde quasi nulle.

5. Dispositif selon la revendication 1, caractérisé en ce qu'une couche métallique est accolée à la première couche de diélectrique (2) du côté opposé à la couche mince supraconductrice (1) et que l'épaisseur de la couche de diélectrique selon la direction de propagation d'une onde à déphaser est sensiblement proportionnelle à un multiple de la moitié de la longueur d'onde à déphaser.

6. Dispositif selon la revendication 1, caractérisé en ce qu'une couche métallique est accolée à la première couche de diélectrique (1) du côté opposé à la couche mince supraconductrice (1) et que l'épaisseur de la première couche diélectrique (2) est sensiblement donnée par la formule :

$$e_1 = k \lambda_o/2 \sqrt{\varepsilon_1} - \lambda^2_L/d$$

dans laquelle

$\lambda_o$, est la longueur d'onde dans le vide,

$\varepsilon_1$, la permittivité relative de la première couche diélectrique,

$\lambda_L$, la profondeur de pénétration dans la couche de supraconducteur,

d, l'épaisseur de la couche supraconductrice,

k, un nombre entier positif.

7. Dispositif selon la revendication 6, caractérisé en ce que les paramètres du dispositif sont ajustés pour obtenir une impédance ramenée réelle de 377 $\Omega$ environ pour une longueur d'onde $\lambda_o$ ayant pour valeur environ $(e_1 + \lambda^2_L/d)2 \sqrt{\varepsilon_1}/k$.

8. Revêtement réducteur de surface équivalente radar selon l'une des revendications 5 ou 6, caractérisé en ce qu'il comporte une pluralité de dispositifs accolés les uns aux autres, certains des dispositifs ayant l'axe optique c de la couche mince supraconductrice (1) contenu dans le plan ( X, Y ) de la couche et parallèle à un l'axe (X), et d'autres dispositifs ayant leur axe c parallèles à l'axe (Y) perpendiculaire au premier axe (X).

9. Brouilleur de polarisation caractérisé en ce qu'il comporte au moins deux dispositifs selon la revendication 6, permettant une double réflexion (dièdre) et dont les axes c sont perpendiculaires ce qui permet de contrôler la polarisation de l'onde réfléchie.

10. Déviateur d'onde électromagnétique caractérisé en ce qu'il comporte plusieurs dispositifs selon la revendication 5, disposés selon un même plan.

11. Déphaseur d'onde électromagnétique, caractérisé en ce qu'il comporte :

– un élément de forme plane comportant un empilement d'une première couche métallique (10), d'une première couche de diélectrique (11) d'une première couche supraconductrice (12) et d'une deuxième couche de diélectrique (13),

– un élément situé sur la deuxième couche de diélectrique (13), ayant sur cette deuxième couche de diélectrique (13) la forme d'un guide d'onde, et comportant un empilement d'une deuxième couche supraconductrice (14), une troisième couche diélectrique (15) et une deuxième couche métallique (16),

– des connexions électriques (17, 18) connectées aux première et deuxième couches supraconductrices ( 12, 14) de façon à alimenter séparément ces couches par des courants (11, 12) permettant de modifier à volonté la densité des paires de Cooper de ces couches

12. Bolomètre caractérisé en ce qu'il comprend un oscillateur comprenant dans sa boucle d'oscillation un déphaseur selon la revendication 11 et que la mesure d'une puissance électromagnétique incidente sur le déphaseur est mesurée par la mesure de la fréquence d'oscillation.

FIG.1

FIG.2

FIG.3

FIG.4a

FIG.4b

FIG.5a

FIG.5b

F = 9,8 GHz

PARTIE IMAGINAIRE DE L'IMPÉDANCE DE SURFACE

PARTIE RÉELLE DE L'IMPÉDANCE DE SURFACE

TEMPÉRATURE RÉDUITE

500

0

−500

1000

50

0,8   0,85   0,9

t

FIG. 6b

VIDE

SUPRA

$\varepsilon = 15$   $Z = 0$

$\lambda_L(0) = 800\,nm$

$\rho_n = 300\,\mu\Omega cm$

1   2

5nm   3,67mm

FIG. 6a

INDUCTANCE DE SURFACE (nH/o)

20

10

0

0,69   0,70   0,71

t

10,096 GHz

10,097 GHz

10,098 GHz

10,1 GHz

FIG. 6c

FIG. 6d

FIG. 7

**FIG. 8a**

**FIG. 8c**

**FIG. 8b**

a ou b

30

32

EM

H

SOURCE

FIG.9

courant de commande

I2

S2

I1

16

15

I

14 (SUPRA)

I

métal

diélectrique

diélectrique

diélectrique

métal

EM

13

12 (SUPRA)

11

10

FIG.10